(19) Europäisches Patentamt
European Patent Office
Office européen des brevets

(11) **EP 4 768 938 A1**

(12) **EUROPEAN PATENT APPLICATION**
published in accordance with Art. 153(4) EPC

(43) Date of publication:
**01.07.2026 Bulletin 2026/27**

(21) Application number: **25833476.2**

(22) Date of filing: **30.06.2025**

(51) International Patent Classification (IPC):
***G01R 31/367*** *(2019.01)* ***G01R 31/392*** *(2019.01)*
***G01R 31/36*** *(2020.01)* ***G01R 31/382*** *(2019.01)*
***G06N 3/0442*** *(2023.01)* ***G06N 20/00*** *(2019.01)*

(52) Cooperative Patent Classification (CPC):
**G01R 31/36; G01R 31/367; G01R 31/382; G01R 31/392; G06N 3/0442; G06N 20/00**

(86) International application number:
**PCT/KR2025/009242**

(87) International publication number:
**WO 2026/010290 (08.01.2026 Gazette 2026/02)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **03.07.2024 KR 20240087431**
**16.06.2025 KR 20250078638**

(71) Applicant: **LG Energy Solution, Ltd.**
**Seoul 07335 (KR)**

(72) Inventors:
- **KIM, Jae Hyun**
**Daejeon 34122 (KR)**
- **CHOI, Yong Kyun**
**Daejeon 34122 (KR)**

(74) Representative: **Plasseraud IP**
**104 Rue de Richelieu**
**CS92104**
**75080 Paris Cedex 02 (FR)**

# (54) BATTERY DIAGNOSTIC APPARATUS AND METHOD THEREOF

(57) According to an embodiment of this document, a battery diagnosis device includes a memory configured to store at least one instruction and at least one processor configured to identify a first input voltage profile including a voltage profile measured by supplying a current having a specified waveform to a battery cell, input the first input voltage profile into a first model which encodes and then restores the first input voltage profile, and diagnose a state of the battery cell based on a feature vector identified based on the first model.

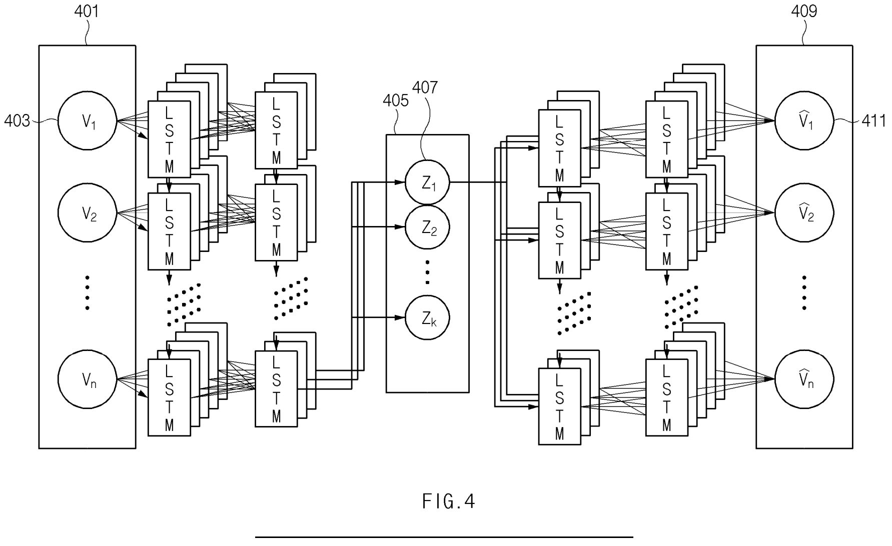


FIG.4

EP 4 768 938 A1

## Description

## TECHNICAL FIELD

### Cross-reference to Related Applications

This application claims priority from Korean Patent Application Nos. 10-2024-0087431, filed on July 3, 2024, and 10-2025-0078638, filed on June 16, 2025, the disclosures of which are incorporated by reference herein.

### Technical Field

Embodiments disclosed in this document relate to a battery diagnosis device and battery diagnosis method.

## BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

With the proliferation of electronic devices due to the Fourth Industrial Revolution, battery usage is increasing dramatically. Batteries are in the spotlight as an essential energy source in various applications, and accordingly, the importance of technology for diagnosing a battery state to improve battery performance and reliability is increasing.

With the recent advancement of artificial intelligence models, battery diagnosis devices that utilize battery data of a battery are being developed. In addition, a plurality of trained models may be used as tools to diagnose the state of battery cells.

## DISCLOSURE OF THE INVENTION

## TECHNICAL PROBLEM

Embodiments disclosed in this document provide a battery diagnosis device and battery diagnosis method that reduce a noise occurrence rate by using a reduced-dimensional feature vector identified in a first model that performs encode and then restore input data.

Embodiments disclosed in this document provide a battery diagnosis device and battery diagnosis method that reduce an overfitting occurrence rate in a second model, which is a regression model, by reducing the noise occurrence rate.

Embodiments disclosed in this document provide a battery diagnosis device and battery diagnosis method that improve a diagnosis accuracy of battery cell state based on a feature vector extracted through a first model that has been subjected to a pattern learning process.

Embodiments disclosed in this document provide a battery diagnosis device and battery diagnosis method that reduce the degradation of training stability due to high-dimensional data processing.

Embodiments disclosed in this document provide a battery diagnosis device and battery diagnosis method that improve training efficiency even when the number of input data is less than or equal to a specified number.

The technical problems of the embodiments disclosed in this document are not limited to the technical problems mentioned above, and other technical problems that are not mentioned may be clearly understood by those skilled in the art from the descriptions below.

## TECHNICAL SOLUTION

A battery diagnosis device according to an embodiment of this document includes a memory configured to store at least one instruction and at least one processor configured to execute the at least one instruction.

According to an embodiment, the at least one processor may be configured to identify a first input voltage profile including a voltage profile measured by supplying a current having a specified waveform to a battery cell, input the first input voltage profile into a first model which encodes and then restores the first input voltage profile, and diagnose a state of the battery cell based on a feature vector identified based on the first model.

According to an embodiment, the at least one processor may be configured to identify the feature vector based on a latent vector, which is a processing result in a bottleneck layer included in the first model.

According to an embodiment, the at least one processor may be configured to diagnose the state of the battery cell based on at least one of at least a portion of the feature vector, at least a portion of the first input voltage profile, at least a portion of a restored voltage profile restored based on the first model, at least a portion of derivatives of the first input voltage profile, or any combination thereof.

According to an embodiment, the at least one processor may be configured to diagnose the state of the battery cell according to at least one of at least a portion of the first input voltage profile, at least a portion of a restored voltage profile restored based on the first model, at least a portion of derivatives of the first input voltage profile, or any combination thereof, and at least a portion of the feature vector, based on the fact that all components of the feature vector fall within pre-specified range, or diagnose the state of the battery cell based on at least the portion of the first input voltage profile, at least the portion of the restored voltage profile restored based on the first model, at least the portion of the derivatives of the first input voltage profile, or any combination thereof, based on the fact that at least one of the components of the feature vector does not fall within the pre-specified range.

According to an embodiment, the at least one processor may be configured to input at least a portion of the feature vector to a second model that outputs the state of the battery cell.

According to an embodiment, the at least one processor may be configured to supply the current to the battery cell within a specified period of time.

According to an embodiment, the state of the battery may include a state of health (SOH).

According to an embodiment, the first model may include a long short term memory autoencoder (LSTM AE) model.

A battery diagnosis method according to another embodiment of this document includes an operation of identifying a first input voltage profile including a voltage profile measured by supplying a current having a specified waveform to a battery cell, an operation of inputting the first input voltage profile into a first model which encodes and then restores the first input voltage profile, and an operation of diagnosing a state of the battery cell based on a feature vector identified based on the first model.

According to an embodiment, the operation of diagnosing the state of the battery cell based on the feature vector identified based on the first model may include an operation of identifying the feature vector based on a latent vector, which is a processing result in a bottleneck layer included in the first model.

According to an embodiment, the operation of diagnosing the state of the battery cell based on the feature vector identified based on the first model may include an operation of diagnosing the state of the battery cell based on at least one of at least a portion of the feature vector, at least a portion of the first input voltage profile, at least a portion of a restored voltage profile restored based on the first model, at least a portion of derivatives of the first input voltage profile, or any combination thereof.

According to an embodiment, the operation of identifying the feature vector based on the latent vector, which is the processing result in the bottleneck layer included in the first model may include an operation of diagnosing the state of the battery cell based on at least one of at least a portion of the first input voltage profile, at least a portion of a restored voltage profile restored based on the first model, at least a portion of derivatives of the first input voltage profile, or any combination thereof, and at least a portion of the feature vector, based on the fact that all components of the feature vector fall within pre-specified range, or an operation of diagnosing the state of the battery cell based on at least a portion of the first input voltage profile, at least a portion of the restored voltage profile restored based on the first model, at least a portion of the derivatives of the first input voltage profile, or any combination thereof, based on the fact that at least one of components of the feature vector does not fall within the pre-specified range.

According to an embodiment, the operation of diagnosing the state of the battery cell based on the feature vector identified based on the first model may include an operation of inputting at least a portion of the feature vector to a second model that outputs the state of the battery cell.

According to an embodiment, the operation of identifying the first input voltage profile including a voltage profile measured by supplying a current having the specified waveform to the battery cell may include an operation of supplying the current to the battery cell within a specified period of time.

According to an embodiment, the state of the battery may include a state of health (SOH).

According to an embodiment, the first model may include a long short term memory autoencoder (LSTM AE) model.

A computer-readable recording medium according to still another embodiment of this document records a program for executing the battery diagnosis method on a computer.

A battery diagnosis device according to still another embodiment of this document includes a memory configured to store at least one instruction and at least one processor configured to execute the at least one instruction.

According to an embodiment, the at least one processor is configured to identify a first input voltage profile by supplying a current having a first waveform to the battery cell, or identify a second input voltage profile based on a current having a second waveform output from the battery cell, input the first input voltage profile or the second input voltage profile into a first model that encodes and then restores the first input voltage profile, and diagnose a state of the battery cell based on a feature vector identified based on the first model.

According to an embodiment, the at least one processor may be configured to identify the first input voltage profile when a degree of charging of the battery cell falls within a pre-specified state range, and identify the second input voltage profile when the degree of charging of the battery cell does not fall within the pre-specified state range.

According to an embodiment, the pre-specified state range may include a value less than a pre-specified state value.

According to an embodiment, the at least one processor may be configured to identify the feature vector based on at least a portion of components of a latent vector that is a result of processing in a bottleneck layer included in the first model.

According to an embodiment, the at least one processor may be configured to diagnose the state of the battery cell based on at least a portion of the feature vector, at least a portion of the first input voltage profile, at least a portion of a restored voltage profile restored based on the first model, at least a portion of derivatives of the first input voltage profile, or any combination thereof, or diagnose the state of the battery cell based on at least a portion of the feature vector, at least a portion of the second input voltage profile, at least a portion of the restored voltage profile restored based on the first model, at least a portion of derivatives of the second input voltage profile, or any combination thereof.

According to an embodiment, the at least one processor may be configured to input at least a portion of the feature vector to a second model that outputs the state of the battery cell.

According to an embodiment, the first model may include a long short term memory autoencoder (LSTM AE) model.

A battery diagnosis method according to still another embodiment of this document includes an operation of identifying a first input voltage profile by supplying a current having a first waveform to the battery cell, or identifying a second input voltage profile based on a current having a second waveform output from the battery cell, an operation of inputting the first input voltage profile or the second input voltage profile into a first model that encodes and then restores the first input voltage profile or the second input voltage profile, and an operation of diagnosing a state of the battery cell based on a feature vector identified based on the first model.

According to an embodiment, the operation of identifying the first input voltage profile by supplying the current having the first waveform to the battery cell, or identifying the second input voltage profile based on the current having the second waveform output from the battery cell may include an operation of identifying the first input voltage profile when a degree of charging of the battery cell falls within a pre-specified state range, and an operation of identifying the second input voltage profile when the degree of charging of the battery cell does not fall within the pre-specified state range.

According to an embodiment, the pre-specified state range may include a value less than a pre-specified state value.

According to an embodiment, the operation of diagnosing the state of the battery cell based on the feature vector identified based on the first model may include an operation of identifying the feature vector based on at least a portion of components of a latent vector that is a result of processing in a bottleneck layer included in the first model.

According to an embodiment, the operation of identifying the feature vector based on at least a portion of components of the latent vector that is a result of processing in the bottleneck layer included in the first model may include an operation of diagnosing the state of the battery cell based on at least a portion of the feature vector, at least a portion of the voltage profile, at least a portion of a restored voltage profile restored based on the first model, at least a portion of derivatives of the first input voltage profile, or any combination thereof, or an operation of diagnosing the state of the battery cell based on at least a portion of the feature vector, at least a portion of the second input voltage profile, at least a portion of the restored voltage profile restored based on the first model, at least a portion of derivatives of the second input voltage profile, or any combination thereof.

According to an embodiment, the operation of diagnosing the state of the battery cell based on the feature vector identified based on the first model may include an operation of inputting at least a portion of the feature vector to a second model that outputs the state of the battery cell.

According to an embodiment, the first model may include a long short term memory autoencoder (LSTM AE) model.

A computer-readable recording medium according to still another embodiment of this document records a program for executing the battery diagnosis method on a computer.

## ADVANTAGEOUS EFFECTS

The present technology can reduce the noise generation rate by using a reduced-dimensional feature vector identified in the first model that performs encoding and then restoration.

In addition, the present technology can reduce the overfitting occurrence rate in the second model, which is a regression model, by reducing the noise occurrence rate.

In addition, the present technology can improve a diagnosis accuracy of the battery cell state based on the feature vector extracted through the first model that has been subjected to a pattern learning process.

In addition, the present technology can reduce the degradation of training stability due to high-dimensional data processing.

In addition, the present technology can improve training efficiency even when the number of input data is less than a specified number.

In addition, various effects that are directly or indirectly identified through this document can be provided.

## BRIEF DESCRIPTION OF THE DRAWINGS

FIG. 1 is a block diagram illustrating a battery pack in a battery diagnosis device and battery diagnosis method according to an embodiment of this document.

FIG. 2 is a block diagram illustrating the configuration of a battery diagnosis device and battery diagnosis method according to an embodiment of this document.

FIG. 3 illustrates an example of a first model that performs encoding and then restoration, in a battery diagnosis device and battery diagnosis method according to an embodiment of this document.

FIG. 4 illustrates an example of an operation in which a voltage profile is processed through a first model that performs encoding and then restoration, in a battery diagnosis device and battery diagnosis method according to an embodiment of this document.

FIG. 5 illustrates an example of an operation of diagnosing life information of a battery cell according to a degree of charging of the battery cell, in a battery diagnosis device and battery diagnosis method according to an embodiment of this document.

FIG. 6 illustrates an example of an operation in which a type of data input into a second model, which is a regression model, changes according to components of a latent vector, in a battery diagnosis device and battery diagnosis method according to an embodiment of this document.

FIG. 7 illustrates an example of an operation in which a value of data input into a second model, which is a regression model, changes according to components of a latent vector in a battery diagnosis device and battery diagnosis method according to an embodiment of this document.

FIG. 8 illustrates an example of an operation in which a method of deriving a state of a battery cell from data output from a second model, which is a regression model, changes according to components of a latent vector, in a battery diagnosis device and battery diagnosis method according to an embodiment of this document.

FIG. 9 illustrates an example of an operation of diagnosing a battery cell, in a battery diagnosis device and battery diagnosis method according to an embodiment of this document.

FIG. 10 illustrates an example of an operation of diagnosing a state of a battery cell based on a voltage profile of the battery cell, which is acquired in a manner determined by a degree of charging of the battery cell, in a battery diagnosis device and battery diagnosis method according to an embodiment of this document.

FIG. 11 is a block diagram illustrating a hardware configuration of a computing system that performs the battery diagnosis method, in a battery diagnosis device and battery diagnosis method according to an embodiment of this document.

## MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

Hereinafter, embodiments of this document will be described in detail with reference to FIGS. 1 to 11.

FIG. 1 is a block diagram showing a battery pack in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV) or an energy storage system (ESS).

According to an embodiment, the battery unit 12 may include at least one battery unit 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for voltage, current, resistance, a state of charge (SOC), a state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values obtained by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

According to an embodiment, the battery management system 20 may include a battery diagnosis device 201 of FIG. 2. According to another embodiment, the battery management system 20 may be a different system from the battery diagnosis device 201 of FIG. 2.

That is, the battery diagnosis device 201 of FIG. 2 may be included in the battery pack 1 or may be configured as another device external to the battery pack 1. Hereinafter, for convenience of description, the description will be made on the assumption that the battery diagnosis device 201 is composed of another device external to the battery pack 1. In addition, the operation of the battery diagnosis device 201 described below may be performed by a BMS in the vehicle, and may also be performed by various devices such as a server, a cloud, a charger, or a discharger.

FIG. 2 is a block diagram showing the configuration of a battery diagnosis device, in a battery diagnosis device and battery diagnosis method according to an embodiment of this document.

Referring to FIG. 2, the battery diagnosis device 201 may include a memory 203 and at least one processor 205. The memory 203 may store at least one instruction. The at least one processor 205 may execute at least one instruction.

According to an embodiment, at least one processor 205 of the battery diagnosis device 201 may identify a voltage profile of a battery cell by supplying a current having a first waveform to the battery cell, or identify the voltage profile of the battery cell based on a second waveform output from the battery cell, and diagnose a state of the battery cell (e.g., life information of the battery cell) based on the identified voltage profile.

According to an embodiment, at least one processor 205 of the battery diagnosis device 201 may diagnose the state of a battery cell based on an input voltage profile and values acquired based on a first model to improve a diagnosis accuracy. In this case, the first model may encode and then restore the input voltage profile.

According to an embodiment, the first model, which encodes and then restores, may be used to improve the diagnosis accuracy of the state of the battery cell (e.g., life information of the battery cell). The first model may be referred to as a long short term memory-autoencoder (LSTM-AE), but the embodiments of this document may not be limited thereto.

According to an embodiment, at least one processor 205 of the battery diagnosis device 201 may input the identified voltage profile as an input voltage profile into the first model.

According to an embodiment, at least one processor 205 of the battery diagnosis device 201 may input at least one of at least a portion of a feature vector identified based on the first model, at least a portion of the input voltage profile, at least a portion of an output voltage profile restored based on the first model, at least a portion of derivatives of the input voltage profile, or any combination thereof, into a second model, which is a regression model.

According to an embodiment, at least one processor 205 of the battery diagnosis device 201 may diagnose the state of the battery cell (e.g., life information of the battery cell) based on values output from the second model, which is the regression model. Specific details are described below with reference to FIGS. 3 and 4.

The life information of the battery cell may include an SOH of the battery cell, and the SOH of the battery cell represents a ratio of the current maximum charging capacity to the initial design capacity of the battery cell, and may be expressed as a value between 0 and 1, or a value between 0% and 100%. Methods such as cycle count-based evaluation, internal resistance change analysis, and/or capacity degradation rate calculation may be used for the measurement of SOH, but the embodiments of this document may not be limited thereto.

FIG. 3 illustrates an example of a first model in a battery diagnosis device and battery diagnosis method according to an embodiment of this document.

Referring to FIG. 3, the first model may include an autoencoder using an LSTM, but the embodiments of this document may not be limited thereto. The first model may receive an input voltage profile, which is time series data, extract a feature vector of data, and reconstruct the input voltage profile, which is input data, based on the feature vector. Here, the LSTM is one of artificial neural networks, and may be defined as a structure that has been improved so that the recurrent neural network (RNN) can reflect long term characteristics.

According to an embodiment, the first model may include an LSTM encoder, a bottleneck layer, and an LSTM decoder. However, the embodiments of this document are not limited thereto, and a first model that does not use the LSTM may include an encoder, a bottleneck layer, and a decoder.

According to an embodiment, the first model may acquire a feature vector in which input data (e.g., an input voltage profile) input is encoded through the LSTM encoder through the bottleneck layer. The feature vector may be lower-dimensional data compared to the input data.

According to an embodiment, the first model may acquire restored data (e.g., a restored voltage profile) by decoding and restoring the feature vector in which the input data is compressed.

According to an embodiment, at least one processor 205 of the battery diagnosis device 201 may diagnose the state of the battery cell according to an output value of a second model, which is a regression model, by inputting at least one of input data, restored data, a feature vector, or a combination thereof into the second model.

The second model may include various types of regression models as well as a linear regression model and a kernel regression model.

According to an embodiment, the battery diagnosis device 201 may be composed of a data collection unit, a feature extraction unit, and a life prediction unit. The feature extraction unit may be configured as the the first model. The life prediction unit may be configured as the the second model. The second model may identify the state of the battery (e.g., life information of the battery) based on parameters identified by the feature extraction unit.

FIG. 4 illustrates an example of an operation in which a voltage profile is processed through the first model in a battery diagnosis device and battery diagnosis method according to an embodiment of this document.

Referring to FIG. 4, a set of input voltage profiles 401 may represent at least one voltage profile measured from each of at least one battery cell included in the battery unit. An input voltage profile 403 included in the set of input voltage profiles 401 may include a voltage profile of a first battery cell among the first battery cell to an n-th battery cell included in the battery unit. The input voltage profile 403 may include a vector representing the voltages of the first battery cell measured over time. For example, the input voltage profile 403 may include a vector representing voltages measured at specified time intervals (e.g., approximately 0.1 second intervals) over a specified period of time (e.g., approximately 60 seconds).

A set of feature vectors 405 may represent at least one latent vector, each of which is a result of processing in a bottleneck layer for each of at least one input voltage profile included in the set of input voltage profiles 401. A feature vector 407 may be identified based on at least a portion of components of the latent vector of the first model for the input voltage profile 403. The number of components of the feature vector (e.g., the feature vector 407) may be smaller than the number of components of the input voltage profile (e.g., the input voltage profile 403).

A set of restored voltage profiles 409 may represent at least one restored voltage profile identified by decoding each of at least one feature vector included in the set of feature vectors 405. A restored voltage profile 411 may represent a restored voltage profile identified by decoding the latent vector 407.

According to an embodiment, the voltage profile of the first battery cell may include a first input voltage profile identified by supplying a current having a first waveform to the battery cell within a specified period of time, or a second input voltage profile identified based on current having a second waveform output from the battery cell.

In this case, which voltage profile among the first input voltage profile and the second input voltage profile is to be identified may be determined according to a degree of charging of the battery cell.

For example, at least one processor 205 of the battery diagnosis device 201 may identify the first input voltage profile by supplying a current having a first waveform to the battery cell within a specified period of time when the degree of charging of the battery cell (e.g., state of charge (SOC) of the battery cell) falls within a pre-specified state range (e.g., an SOC of less than approximately 50%).

This is because, when the degree of charging of the battery cell is lower than a pre-specified state value, the stability of the voltage profile acquired by charging the battery cell is higher than the stability of the voltage profile acquired by discharging the battery cell. Furthermore, this is because, when the degree of charging of the battery cell is lower than the pre-specified state value, the magnitude of the current that can be supplied to the battery cell during charging is greater than the magnitude of the current that the battery cell can output during discharging. Therefore, when the degree of charging of a battery cell is lower than a pre-specified state value, a diagnosis accuracy of a method of diagnosing the state of the battery (e.g., life information of the battery such as the SOH) based on the first input voltage profile may be higher than that of a method of diagnosing the state of the battery based on the second input voltage profile.

For example, at least one processor 205 of the battery diagnosis device 201 may identify the second input voltage profile based on a current having the second waveform output from the battery cell when the degree of charging of the battery cell (e.g., the SOC of the battery cell) does not fall within the pre-specified state range (e.g., the SOC less than approximately 50%). The first waveform and the second waveform may be the same or different.

This is because, when the degree of charging of the battery cell is greater than the pre-specified state value, the stability of the voltage profile acquired by discharging the battery cell is higher than the stability of the voltage profile acquired by charging the battery cell. In addition, this is because, when the degree of charging of the battery cell is greater than the pre-specified state value, the magnitude of current that the battery cell can output during discharging is greater than the magnitude of current that can be supplied to the battery cell during charging. Therefore, when the degree of charging of the battery cell is greater than the pre-specified state value, the diagnosis accuracy of a method of diagnosing the state of the battery (e.g., life information of the battery such as SOH) based on the second input voltage profile may be higher than the diagnosis accuracy of a method of diagnosing the state of the battery based on the first input voltage profile.

Accordingly, at least one processor 205 of the battery diagnosis device 201 may diagnose the state of the battery cell regardless of the degree of charging of the battery cell. In addition, since at least one processor 205 of the battery diagnosis device 201 identifies an input voltage profile (e.g., a first input voltage profile or a second input voltage profile) within a specified period of time, the input voltage profile can be identified in a shorter time compared to the time required to identify a voltage profile in a conventional battery diagnosis method, and the battery diagnosis can be performed in a shorter time compared to the time required in a conventional battery diagnosis method.

According to an embodiment, at least one processor 205 of the battery diagnosis device 201 may identify the state of the battery cell (e.g., the SOH of the battery cell) based on at least one of the input voltage profile 403 (e.g., the first input voltage profile or the second input voltage profile), at least a portion of the feature vector 407, at least a portion of the restored voltage profile 411, at least a portion of derivatives of the input voltage profile 403, or any combination thereof.

The second model, which is a regression model, may output parameters representing the state of the battery cell cell (e.g., the SOH of the battery cell) as a continuous value based on a regression equation, such as Equation 1, using at least a portion of the input voltage profile 403, at least a portion of the feature vector 407, at least a portion of the restored voltage profile 411, at least a portion of the derivatives of the input voltage profile 403, or any combination thereof.

[Equation 1]

$$SOH = \alpha_1 x_1 + \alpha_2 x_2 + \cdots + \alpha_n x_n$$

The SOH may represent may represent the life information of the battery cell. $\alpha_1$, $\alpha_2$, and $\alpha_n$ are regression weights that may be determined through training of the second model. $x_1$, $x_2$, and $x_n$ may include at least one of at least a portion of the input voltage profile 403, at least a portion of the feature vector 407, at least a portion of the restored voltage profile 411, at least a portion of the derivatives of the input voltage profile 403, or any combination thereof. Parameters included in the regression equation may be pre-specified. In addition, Equation 1 is in the form of multiple linear equations, but the regression equation included in the embodiments of this document may not be limited thereto.

FIG. 5 illustrates an example of an operation of diagnosing life information of a battery cell according to a degree of charging of the battery cell in a battery diagnosis device and battery diagnosis method according to an embodiment of the present document.

Hereinafter, it is assumed that at least one processor 205 of the battery diagnosis device 201 of FIG. 5 performs the process of FIG. 5. Furthermore, in the description of FIG. 5, the operations described as being performed by the battery diagnosis device 201 may be understood as being controlled by at least one processor 205 of the battery diagnosis device 201.

Referring to FIG. 5, in a first operation (501), at least one processor 205 of the battery diagnosis device 201 according to an embodiment may identify whether the degree of charging of a battery cell falls within a pre-specified state range (e.g., an SOC range of less than approximately 50%). When the the degree of charging of the battery cell falls within the pre-specified state range, at least one processor 205 of the battery diagnosis device 201 may perform a second operation (503). When the degree of charging of the battery cell does not fall within the pre-specified state range, at least one processor 205 of the battery diagnosis device 201 may perform a third operation (517).

In the second operation (503), at least one processor 205 of the battery diagnosis device 201 according to an embodiment may supply a current having a first waveform to the battery cell.

In a fourth operation (505), at least one processor 205 of the battery diagnosis device 201 according to an embodiment may identify a first input voltage profile. For example, a data collection unit included in the battery diagnosis device 201 may perform the fourth operation (505).

In a fifth operation (507), at least one processor 205 of the battery diagnosis device 201 according to an embodiment may normalize the first input voltage profile.

For example, at least one processor 205 of the battery diagnosis device 201 may normalize the first input voltage profile by dividing a value obtained by subtracting the minimum value of the first input voltage profile from the first input voltage profile by a value obtained by subtracting the minimum value of the first input voltage profile from the maximum value of the first input voltage profile.

For example, a feature extraction unit included in the battery diagnosis device 201 may perform the fifth operation (507).

In a sixth operation (509), at least one processor 205 of the battery diagnosis device 201 according to an embodiment may input the normalized first input voltage profile into a first model. The first model may include a model that performs encoding and then restoration.

For example, the feature extraction unit included in the battery diagnosis device 201 may perform the sixth operation (509).

In a seventh operation (511), at least one processor 205 of the battery diagnosis device 201 according to an embodiment may identify a feature vector and a restored voltage profile based on the first model.

For example, the feature extraction unit included in the battery diagnosis device 201 may perform the seventh operation (511).

In an eighth operation (513), at least one processor 205 of the battery diagnosis device 201 according to an embodiment may input at least one of at least a portion of the feature vector, at least a portion of the first input voltage profile, at least a portion of the restored voltage profile, at least a portion of the derivatives of the first input voltage profile, or any combination thereof, into a second model. The second model may include a regression model.

For example, the types of parameters input into the second model may be pre-specified, or determined according to pre-specified criteria. Referring to FIGS. 6 to 7, examples of criteria for determining the types of parameters are described.

For example, a profile input into the second model among parameters may be determined according to the pre-specified criterion. For example, at least one processor 205 of the battery diagnosis device 201 may input at least one of at least one component in a pre-specified order among components of the feature vector, at least one component in a pre-specified order among components of the first input voltage profile, at least one component in a pre-specified order among components of the restored voltage profile, at least one value in a pre-specified order among at least one derivatives of the first input voltage profile, or any combination thereof to the seconds model.

For example, the life prediction unit included in the battery diagnosis device 201 may perform the eighth operation (513).

In a ninth operation (515), at least one processor 205 of the battery diagnosis device 201 according to an embodiment may estimate the SOH of the battery cell based on the second model.

For example, the life prediction unit included in the battery diagnosis device 201 may perform the ninth operation (515).

In the third operation (517), at least one processor 205 of the battery diagnosis device 201 according to an embodiment may output a current having a second waveform from the battery cell.

In a tenth operation (519), at least one processor 205 of the battery diagnosis device 201 according to an embodiment may identify a second input voltage profile.

For example, the data collection unit included in the battery diagnosis device 201 may perform the tenth operation (519).

In an eleventh operation (521), at least one processor 205 of the battery diagnosis device 201 according to an embodiment may normalize the second input voltage profile.

For example, as in the fifth operation (507) at least one processor 205 of the battery diagnosis device 201 may normalize the second input voltage profile by dividing a value obtained by subtracting the minimum value of the second input voltage profile from the second input voltage profile by a value obtained by subtracting the minimum value of the second input voltage profile from the maximum value of the second input voltage profile.

For example, the feature extraction unit included in the battery diagnosis device 201 may perform the eleventh operation (521).

In a twelfth operation (523), at least one processor 205 of the battery diagnosis device 201 according to an embodiment may input the second input voltage profile into the first model.

For example, the feature extraction unit included in the battery diagnosis device 201 may perform the twelfth operation (523).

In a thirteenth operation (525), at least one processor 205 of the battery diagnosis device 201 according to an embodiment may identify a feature vector and a restored voltage profile based on the first model.

For example, the feature extraction unit included in the battery diagnosis device 201 may perform the thirteenth operation (525).

In a fourteenth operation (527), at least one processor 205 of the battery diagnosis device 201 according to an embodiment may input at least one of at least a portion of the feature vector, at least a portion of the second input voltage profile, at least a portion of the restored voltage profile, at least a portion of the derivatives of the second input voltage profile, or any combination thereof, into the second model.

For example, as in the eighth operation (513), an example of a criterion for determining the type of parameter is described with reference to FIGS. 6 and 7.

For example, as in the eighth operation (513), the profile input into the second model among the parameters may be determined according to a pre-specified criterion.

For example, the life prediction unit included in the battery diagnosis device 201 may perform the fourteenth operation (527).

In a fifteenth operation (529), at least one processor 205 of the battery diagnosis device 201 according to an embodiment may estimate the SOH of the battery cell based on the second model.

For example, the life prediction unit included in a battery diagnosis device 201 may perform the fifteenth operation (529).

FIG. 6 illustrates an example of an operation in which a type of data input into a second model, which is a regression model, changes according to components of a latent vector in a battery diagnosis device and battery diagnosis method according to an embodiment of this document.

Hereinafter, it is assumed that at least one processor 205 of the battery diagnosis device 201 of FIG. 6 performs the process of FIG. 6. Furthermore, in the description of FIG. 6, the operations described as being performed by the battery diagnosis device 201 may be understood as being controlled by at least one processor 205 of the battery diagnosis device 201.

A first operation (601), a second operation (603), and a third operation (605) may be performed in place of the eighth operation (513) and the ninth operation (515) of FIG. 5, or may be performed in place of the fourteenth operation (527) and the fifteenth operation (529).

Referring to FIG. 6, in the first operation (601), at least one processor 205 of the battery diagnosis device 201 according to an embodiment may identify whether all components of the feature vector fall within a pre-specified range (e.g., a range less than a pre-specified feature value). When all components of the feature vector fall within the pre-specified range, at least one processor 205 of the battery diagnosis device 201 may perform the second operation (603). When any of the components of the feature vector does not fall within the pre-specified range, at least one processor 205 of the battery diagnosis device 201 may perform the third operation (605).

In the second operation (603), at least one processor 205 of a battery diagnosis device 201 according to an embodiment may estimate a first SOH of the battery cell by inputting at least a portion of the input voltage profile (e.g., the first input voltage profile or the second input voltage profile), at least a portion of the restored voltage profile (e.g., a restored voltage profile for the first input voltage profile or a restored voltage profile for the second input voltage profile), at least a portion of the derivatives of the input voltage profile, or any combination thereof, and at least a portion of the feature vector into the second model when all components of the feature vector fall within a pre-specified range.

In the third operation (605), at least one processor 205 of the battery diagnosis device 201 according to an embodiment may estimate a second SOH of the battery cell by inputting at least a portion of the input voltage profile (e.g., the first input voltage profile or the second input voltage profile), at least a portion of the restored voltage profile (e.g., a restored voltage profile for the first input voltage profile or a restored voltage profile for the second input voltage profile), at least a portion of the derivatives of the input voltage profile, or any combination thereof, into the second model.

In other words, when at least one of the components of the feature vector does not fall within the pre-specified range, noise may occur in the feature vector, and therefore, at least one processor 205 of the battery diagnosis device 201 may identify the life information of the battery cell (e.g., the second SOH) by inputting at least one parameter excluding the feature vector into the second model to reduce the impact of noise.

According to an embodiment, in the battery diagnosis device 201 performing the operation of FIG. 6, the type of parameters input into the second model may change as the components of the feature vector gradually increase or decrease.

FIG. 7 illustrates an example of an operation in which the value of data input into the second model, which is a regression model, changes according to the components of the latent vector in the battery diagnosis device and battery diagnosis method according to an embodiment of this document.

Hereinafter, it is assumed that at least one processor 205 of the battery diagnosis device 201 of FIG. 7 performs the process of FIG. 7. Furthermore, in the description of FIG. 7, the operations described as being performed by the battery diagnosis device 201 may be understood as being controlled by at least one processor 205 of the battery diagnosis device 201.

A first operation (701), a second operation (703), and a third operation (705) may be performed in place of the eighth operation (513) and the ninth operation (515) of FIG. 5, or may be performed in place of the fourteenth operation (527) and the fifteenth operation (529).

Referring to FIG. 7, in the first operation (701), at least one processor 205 of the battery diagnosis device 201 according to an embodiment may identify whether all components of the feature vector fall within a pre-specified range (e.g., a range less than a pre-specified feature value). When all components of the feature vector fall within the pre-specified range, at least one processor 205 of the battery diagnosis device 201 may perform the second operation (703). When any of the components of the feature vector does not fall within the pre-specified range, at least one processor 205 of the battery diagnosis device 201 according to an embodiment may perform the third operation (705).

In the second operation (703), at least one processor 205 of the battery diagnosis device 201 according to an embodiment may estimate a first SOH of the battery cell by inputting at least a portion of the input voltage profile, at least a portion of the restored voltage profile, at least a portion of the derivatives of the input voltage profile, or any combination thereof, and at least a portion of the feature vector into the second model.

In the third operation (705), at least one processor 205 of the battery diagnosis device 201 according to an embodiment may replace any component of components of the feature vector that does not fall within a pre-specified range with a boundary value of the pre-specified range.

In other words, since noise may occur in the feature vector, at least one processor 205 of the battery diagnosis device 201 may replace any component that is greater than an upper limit value of a pre-specified range among the components of the feature vector with the upper limit value, and replace any component that is less than a lower limit value of the pre-specified range among the components of the feature vector with the lower limit, in order to reduce the impact of noise. Thereafter, at least one processor 205 of the battery diagnosis device 201 may perform the second operation (703) based on the feature vector with some of the components replaced.

According to an embodiment, in the battery diagnosis device 201 performing the operation of FIG. 7, as the components of the feature vector gradually increase or decrease, a parameter indicating the state of the battery cell (e.g., the state of health (SOH) of the battery cell) may converge to a specific value.

FIG. 8 illustrates an example of an operation in which a method of deriving a state of the battery cell from data output from a second model, which is a regression model, changes according to components of a latent vector, in a battery diagnosis device and battery diagnosis method according to an embodiment of this document.

Hereinafter, it is assumed that at least one processor 205 of the battery diagnosis device 201 of FIG. 8 performs the process of FIG. 8. Furthermore, in the description of FIG. 8, the operations described as being performed by the battery diagnosis device 201 may be understood as being controlled by at least one processor 205 of the battery diagnosis device 201.

A first operation (801), a second operation (803), and a third operation (805) may be performed in place of the eighth operation (513) and the ninth operation (515) of FIG. 5, or may be performed in place of the fourteenth operation (527) and the fifteenth operation (529).

In the first operation (801), at least one processor 205 of the battery diagnosis device 201 according to an embodiment may identify whether all components of the feature vector fall within a pre-specified range (e.g., a range less than a pre-specified feature value). When all components of the feature vector fall within the pre-specified range, at least one processor 205 of the battery diagnosis device 201 according to an embodiment may perform the second operation (803). When at least one component of the components of the feature vector does not fall within the pre-specified range, at least one processor 205 of the battery diagnosis device 201 according to an embodiment may perform the third operation (805).

In the second operation (803), at least one processor 205 of the battery diagnosis device 201 according to an embodiment may estimate an SOH of the battery cell based on a first SOH and a second SOH.

The first SOH may represent an SOH output from the second model by inputting at least a portion of the input voltage profile, at least a portion of the restored voltage profile, at least a portion of the derivatives of the input voltage profile, or any combination thereof, and at least one of the feature vectors into the second model.

The second SOH may represent an SOH output from the second model by inputting at least a portion of the input voltage profile, at least a portion of the restored voltage profile, at least a portion of the derivatives of the input voltage profile, or any combination thereof into the second model.

For example, at least one processor 205 of the battery diagnosis device 201 may estimate the SOH of the battery cell based on an average value of the first SOH and the second SOH.

In the third operation (805), at least one processor 205 of the battery diagnosis device 201 according to an embodiment may estimate the SOH of the battery cell based on the second SOH. In other words, since noise may occur in the feature vector, at least one processor 205 of the battery diagnosis device 201 may estimate the SOH of the battery cell with the second SOH to reduce the impact of noise.

According to an embodiment, in the battery diagnosis device 201 performing the operation of FIG. 6, as the components of the feature vector gradually increase or decrease, the type of parameter input into the second model and the method of deriving the state of the battery cell may be changed.

FIG. 9 illustrates an example of an operation of diagnosing the state of a battery cell, in a battery diagnosis device and battery diagnosis method according to an embodiment of this document.

Hereinafter, it is assumed that at least one processor 205 of the battery diagnosis device 201 of FIG. 9 performs the process of FIG. 9. Furthermore, in the description of FIG. 9, the operations described as being performed by the battery diagnosis device 201 may be understood as being controlled by at least one processor 205 of the battery diagnosis device 201.

In a first operation (901), at least one processor 205 of the battery diagnosis device 201 according to an embodiment may identify a first input voltage profile measured by supplying a current having a first waveform to a battery cell.

In a second operation (903), at least one processor 205 of the battery diagnosis device 201 according to an embodiment may input the first input voltage profile into a first model. The first model may include a model that performs encoding and then restoration.

In a third operation (905), at least one processor 205 of the battery diagnosis device 201 according to an embodiment may diagnose the state of the battery cell based on a feature vector identified based on the first model.

FIG. 10 illustrates an example of an operation of diagnosing a state of a battery cell based on a voltage profile of the battery cell, which is acquired in a manner determined by a degree of charging of the battery cell, in a battery diagnosis device and battery diagnosis method according to an embodiment of this document.

Hereinafter, it is assumed that at least one processor 205 of the battery diagnosis device 201 of FIG. 10 performs the process of FIG. 10. Furthermore, in the description of FIG. 10, the operations described as being performed by the battery diagnosis device 201 may be understood as being controlled by at least one processor 205 of the battery diagnosis device 201.

In a first operation (1001), at least one processor 205 of the battery diagnosis device 201 according to an embodiment may identify a first input voltage profile by supplying a current having a first waveform to a battery cell, or identify a second input voltage profile based on a current having a second waveform output from the battery cell.

In a second operation (1003), at least one processor 205 of the battery diagnosis device 201 according to an embodiment may input the first input voltage profile or the second input voltage profile into a first model.

In a third operation (1005), at least one processor 205 of the battery diagnosis device 201 according to an embodiment may diagnose a state of the battery cell based on a feature vector identified based on the first model.

FIG. 11 is a block diagram illustrating a hardware configuration of a computing system that performs a battery diagnosis method, in a battery diagnosis device and battery diagnosis method according to an embodiment of this document.

Referring to FIG. 11, a computing system 1100 according to an embodiment disclosed in this document may include an MCU 1110, a memory 1120, an input/output interface 1130, and a communication interface 1140.

The MCU 1110 may be one or more processors that executes various programs (e.g., battery cell data collection program, graph generation program, data analysis program, data decomposition algorithm, normalization program, and battery cell diagnosis program, etc.) stored in the memory 1220, processes various information including battery cell characteristic data, latent variables, etc. through these programs, and performs the functions of the battery diagnosis device 101 shown in FIGS. 2 to 10 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device (not shown) such as a display with the MCU 1110.

The communication I/F 1140 is a configuration that can transmit and receive various data with the server, and may be various devices that can support wired or wireless communication. For example, the battery diagnosis device 201 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

**1.** A battery diagnosis device, comprising:

a memory configured to store at least one instruction; and
at least one processor configured to execute the at least one instruction,
wherein the at least one processor is configured to:

identify a first input voltage profile including a voltage profile measured by supplying a current having a specified waveform to a battery cell;
input the first input voltage profile into a first model which encodes and then restores the first input voltage profile; and
diagnose a state of the battery cell based on a feature vector identified based on the first model.

**2.** The battery diagnosis device of claim 1, wherein the at least one processor is configured to identify the feature vector based on a latent vector, which is a processing result in a bottleneck layer included in the first model.

**3.** The battery diagnosis device of claim 2, wherein the at least one processor is configured to diagnose the state of the battery cell based on at least one of at least a portion of the feature vector, at least a portion of the first input voltage profile, at least a portion of a restored voltage profile restored based on the first model, at least a portion of derivatives of the first input voltage profile, or any combination thereof.

**4.** The battery diagnosis device of claim 2, wherein the at least one processor is configured to:

diagnose the state of the battery cell according to at least one of at least a portion of the first input voltage profile, at least a portion of a restored voltage profile restored based on the first model, at least a portion of derivatives of the first input voltage profile, or any combination thereof, and at least a portion of the feature vector, based on the fact that all components of the feature vector fall within pre-specified range; or
diagnose the state of the battery cell based on at least the portion of the first input voltage profile, at least the portion of the restored voltage profile restored based on the first model, at least the portion of the derivatives of the first input voltage profile, or any combination thereof, based on the fact that at least one of the components of the feature vector does not fall within the pre-specified range.

**5.** The battery diagnosis device of claim 1, wherein the at least one processor is configured to input at least a portion of the feature vector to a second model that outputs the state of the battery cell.

**6.** The battery diagnosis device of claim 1, wherein the at least one processor is configured to supply the current to the battery cell within a specified period of time.

**7.** The battery diagnosis device of claim 1, wherein the state of the battery may include a state of health (SOH).

**8.** The battery diagnosis device of claim 1, wherein the first model includes a long short term memory autoencoder (LSTM AE) model.

**9.** A battery diagnosis method comprising:

an operation of identifying a first input voltage profile including a voltage profile measured by supplying a current having a specified waveform to a battery cell;
an operation of inputting the first input voltage profile into a first model which encodes and then restores the first input voltage profile; and
an operation of diagnosing a state of the battery cell based on a feature vector identified based on the first model.

**10.** The battery diagnosis method of claim 9, wherein the operation of diagnosing the state of the battery cell based on the feature vector identified based on the first model includes an operation of identifying the feature vector based on a latent vector, which is a processing result in a bottleneck layer included in the first model.

**11.** The battery diagnosis method of claim 10, wherein the operation of diagnosing the state of the battery cell based on the feature vector identified based on the first model includes an operation of diagnosing the state of the battery cell based on at least one of at least a portion of the feature vector, at least a portion of the first input voltage profile, at least a portion of a restored voltage profile restored based on the first model, at least a portion of derivatives of the first input voltage profile, or any combination thereof.

**12.** The battery diagnosis method of claim 10, wherein the operation of identifying the feature vector based on the latent vector, which is the processing result in the bottleneck layer included in the first model includes:

an operation of diagnosing the state of the battery cell based on at least one of at least a portion of the first input voltage profile, at least a portion of a restored voltage profile restored based on the first model, at least a portion of derivatives of the first input voltage profile, or any combination thereof, and at least a portion of the feature vector, based on the fact that all components of the feature vector fall within pre-specified range; or
an operation of diagnosing the state of the battery cell based on at least a portion of the first input voltage profile, at least a portion of the restored voltage profile restored based on the first model, at least a portion of the derivatives of the first input voltage profile, or any combination thereof, based on the fact that at least one of components of the feature vector does not fall within the pre-specified range.

**13.** The battery diagnosis method of claim 9, wherein the operation of diagnosing the state of the battery cell based on the feature vector identified based on the first model includes an operation of inputting at least a portion of the feature vector to a second model that outputs the state of the battery cell.

**14.** The battery diagnosis method of claim 9, wherein the operation of identifying the first input voltage profile including a voltage profile measured by supplying a current having the specified waveform to the battery cell includes an operation of supplying the current to the battery cell within a specified period of time.

**15.** The battery diagnosis method of claim 9, wherein the state of the battery includes a state of health (SOH).

**16.** The battery diagnosis method of claim 9, wherein the first model includes a long short term memory autoencoder (LSTM AE) model.

**17.** A computer-readable recording medium having recorded thereon a program for executing the method according to any one of claims 9 to 16 on a computer.

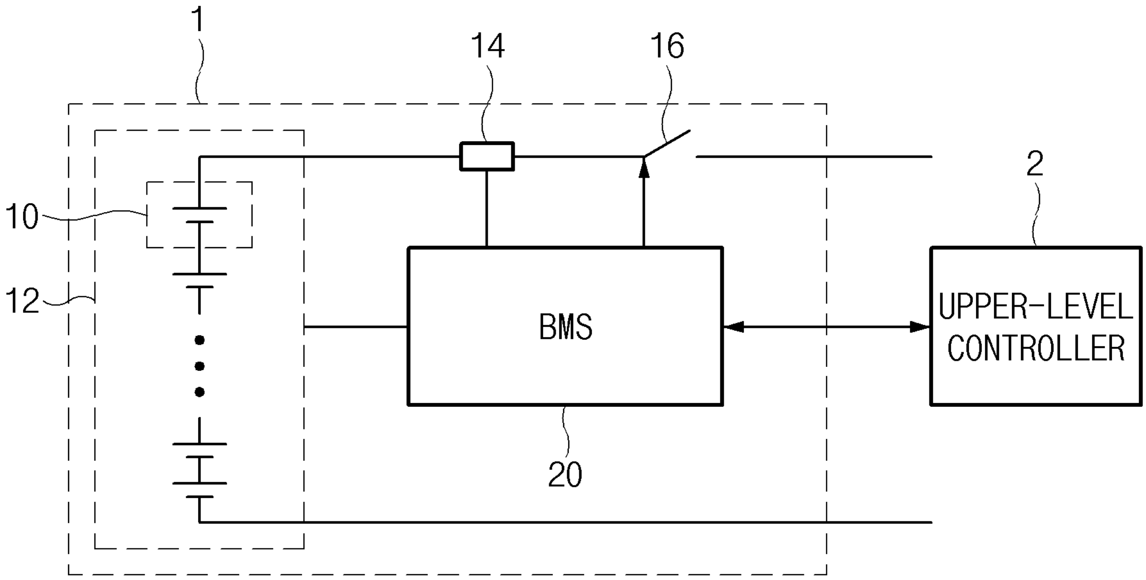


FIG.1

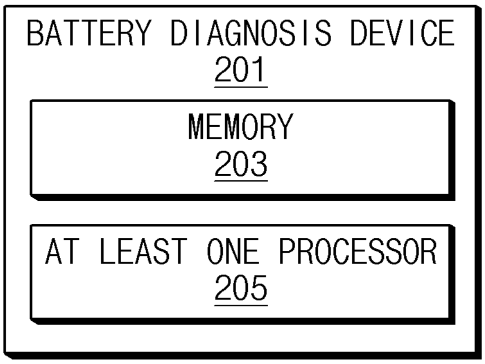
BATTERY DIAGNOSIS DEVICE
201
MEMORY
203
AT LEAST ONE PROCESSOR
205

FIG.2

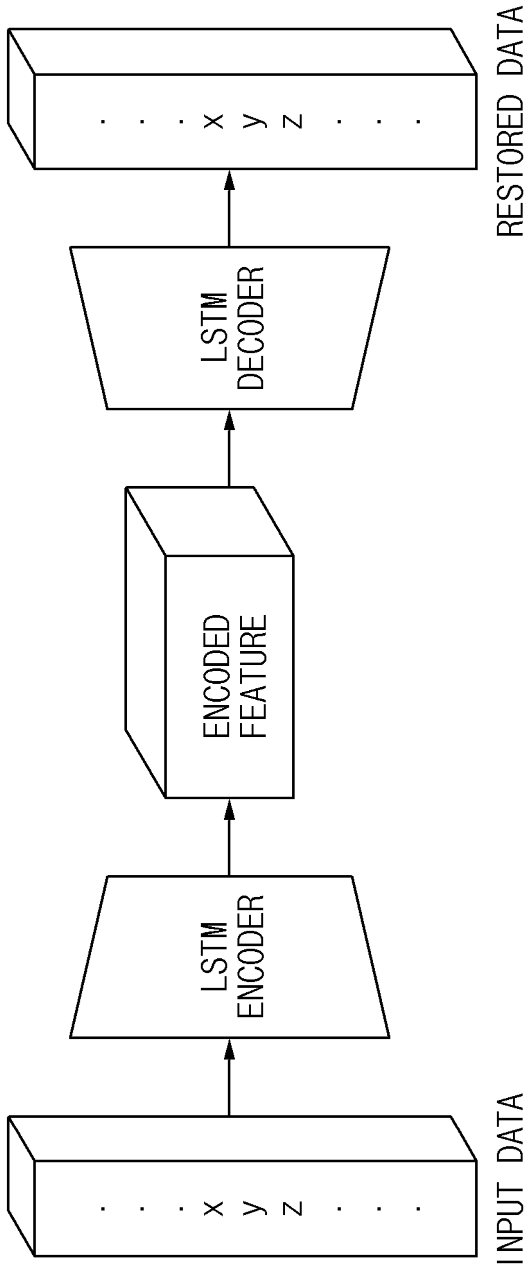
INPUT DATA
· · · x y z · · ·
LSTM ENCODER
ENCODED FEATURE
LSTM DECODER
RESTORED DATA
· · · x y z · · ·

FIG.3

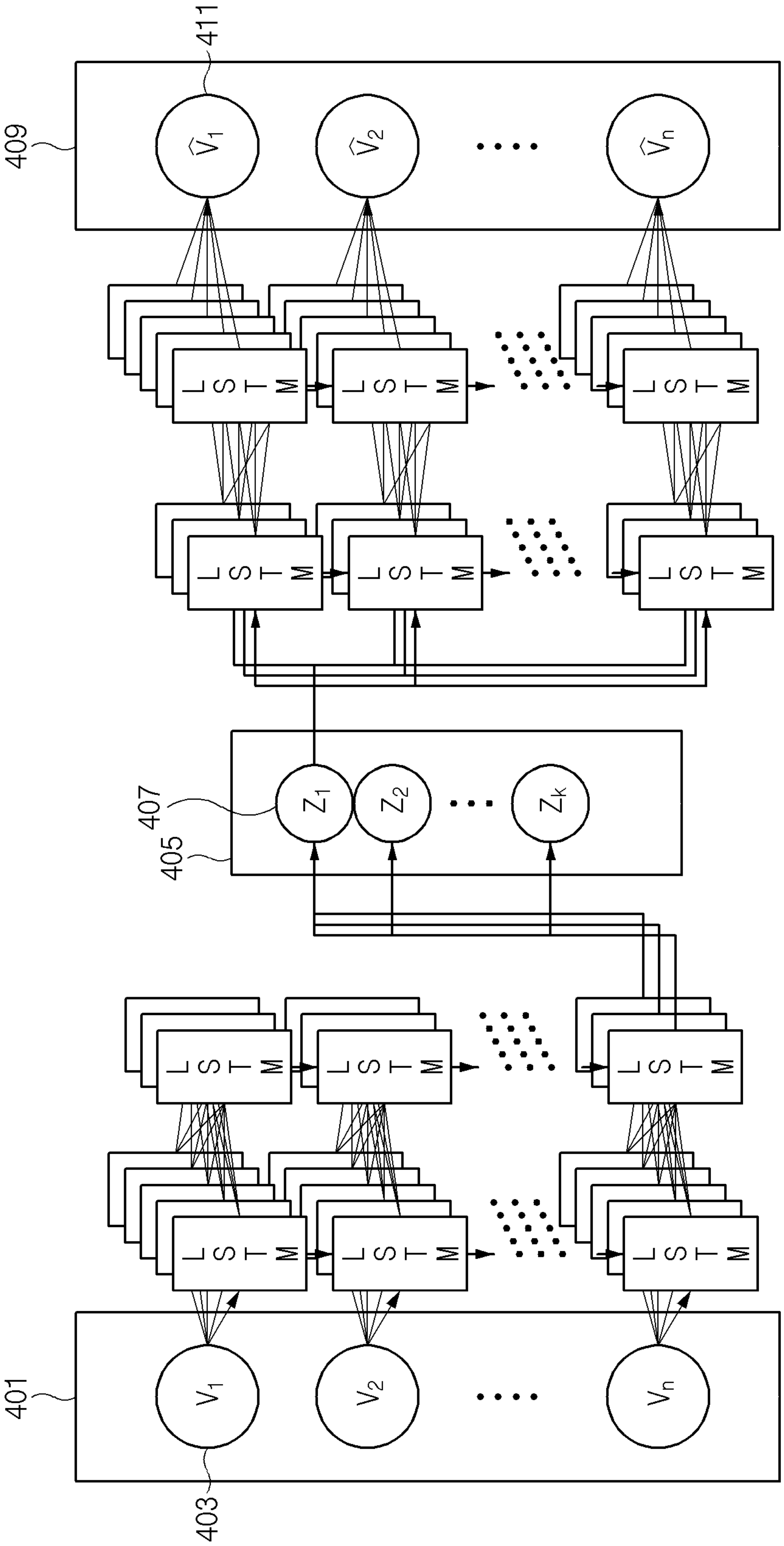


FIG. 4

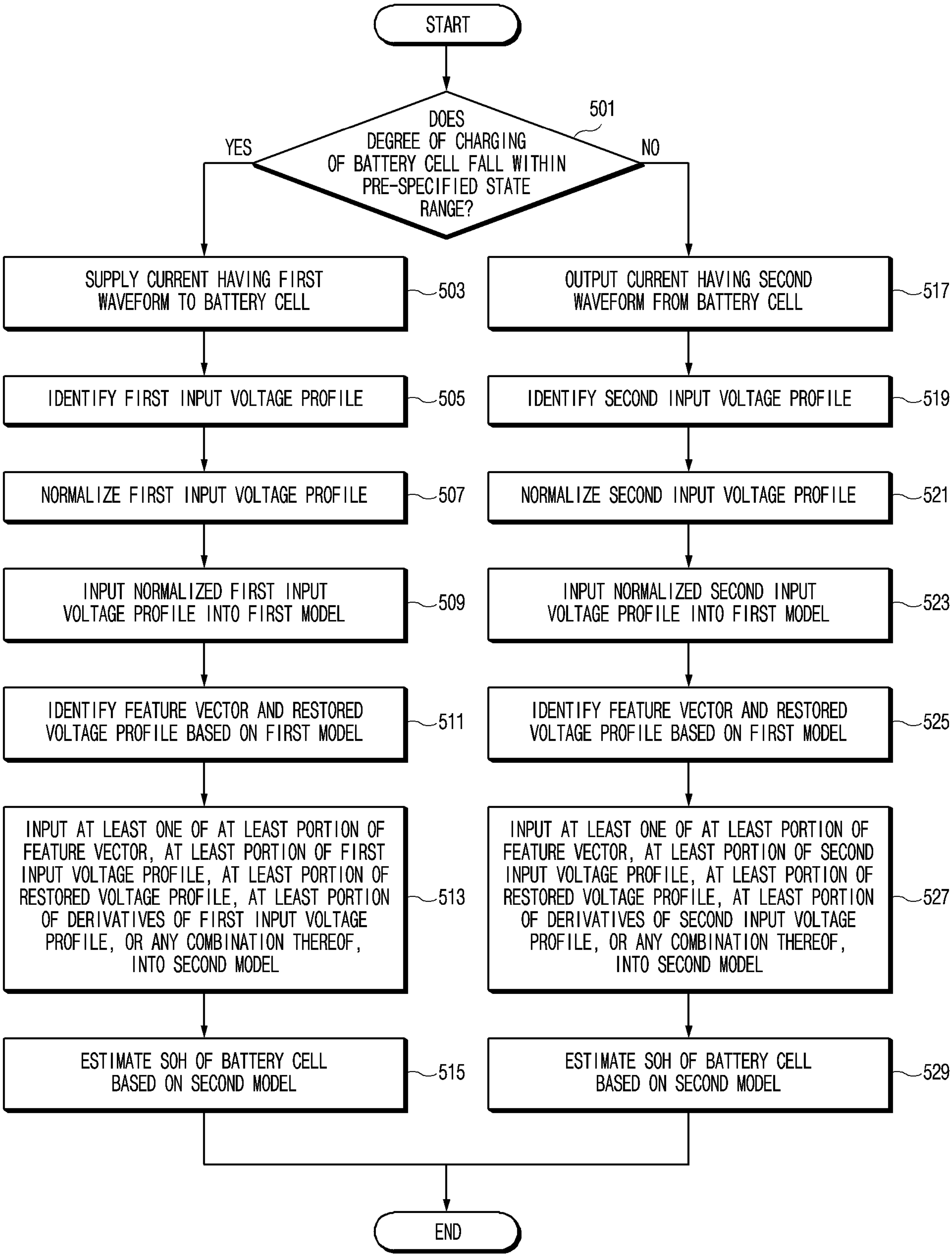
START
DOES DEGREE OF CHARGING OF BATTERY CELL FALL WITHIN PRE-SPECIFIED STATE RANGE?
501
YES
NO
SUPPLY CURRENT HAVING FIRST WAVEFORM TO BATTERY CELL
503
IDENTIFY FIRST INPUT VOLTAGE PROFILE
505
NORMALIZE FIRST INPUT VOLTAGE PROFILE
507
INPUT NORMALIZED FIRST INPUT VOLTAGE PROFILE INTO FIRST MODEL
509
IDENTIFY FEATURE VECTOR AND RESTORED VOLTAGE PROFILE BASED ON FIRST MODEL
511
INPUT AT LEAST ONE OF AT LEAST PORTION OF FEATURE VECTOR, AT LEAST PORTION OF FIRST INPUT VOLTAGE PROFILE, AT LEAST PORTION OF RESTORED VOLTAGE PROFILE, AT LEAST PORTION OF DERIVATIVES OF FIRST INPUT VOLTAGE PROFILE, OR ANY COMBINATION THEREOF, INTO SECOND MODEL
513
ESTIMATE SOH OF BATTERY CELL BASED ON SECOND MODEL
515
OUTPUT CURRENT HAVING SECOND WAVEFORM FROM BATTERY CELL
517
IDENTIFY SECOND INPUT VOLTAGE PROFILE
519
NORMALIZE SECOND INPUT VOLTAGE PROFILE
521
INPUT NORMALIZED SECOND INPUT VOLTAGE PROFILE INTO FIRST MODEL
523
IDENTIFY FEATURE VECTOR AND RESTORED VOLTAGE PROFILE BASED ON FIRST MODEL
525
INPUT AT LEAST ONE OF AT LEAST PORTION OF FEATURE VECTOR, AT LEAST PORTION OF SECOND INPUT VOLTAGE PROFILE, AT LEAST PORTION OF RESTORED VOLTAGE PROFILE, AT LEAST PORTION OF DERIVATIVES OF SECOND INPUT VOLTAGE PROFILE, OR ANY COMBINATION THEREOF, INTO SECOND MODEL
527
ESTIMATE SOH OF BATTERY CELL BASED ON SECOND MODEL
529
END

FIG.5

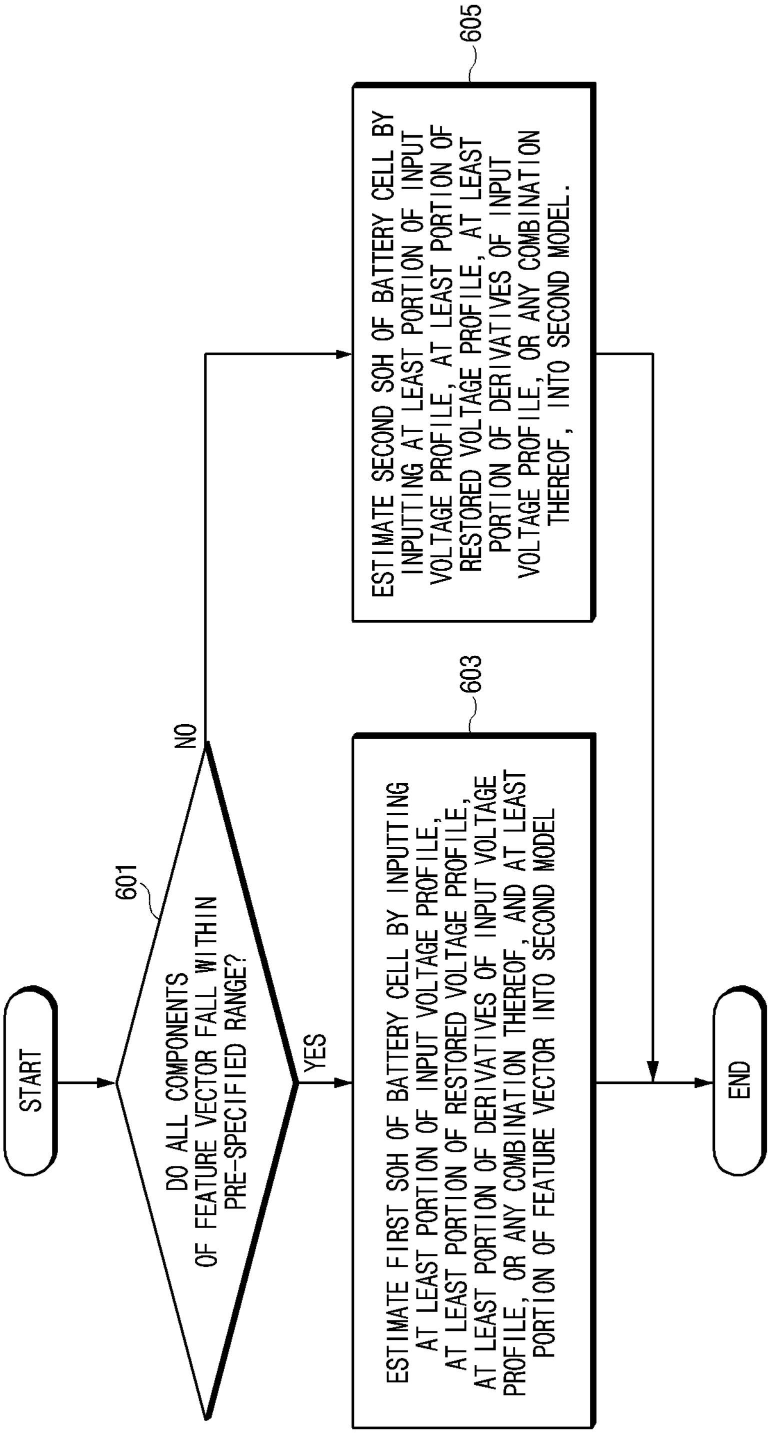
START
DO ALL COMPONENTS OF FEATURE VECTOR FALL WITHIN PRE-SPECIFIED RANGE?
601
YES
NO
ESTIMATE FIRST SOH OF BATTERY CELL BY INPUTTING AT LEAST PORTION OF INPUT VOLTAGE PROFILE, AT LEAST PORTION OF RESTORED VOLTAGE PROFILE, AT LEAST PORTION OF DERIVATIVES OF INPUT VOLTAGE PROFILE, OR ANY COMBINATION THEREOF, AND AT LEAST PORTION OF FEATURE VECTOR INTO SECOND MODEL
603
ESTIMATE SECOND SOH OF BATTERY CELL BY INPUTTING AT LEAST PORTION OF INPUT VOLTAGE PROFILE, AT LEAST PORTION OF RESTORED VOLTAGE PROFILE, AT LEAST PORTION OF DERIVATIVES OF INPUT VOLTAGE PROFILE, OR ANY COMBINATION THEREOF, INTO SECOND MODEL.
605
END

FIG.6

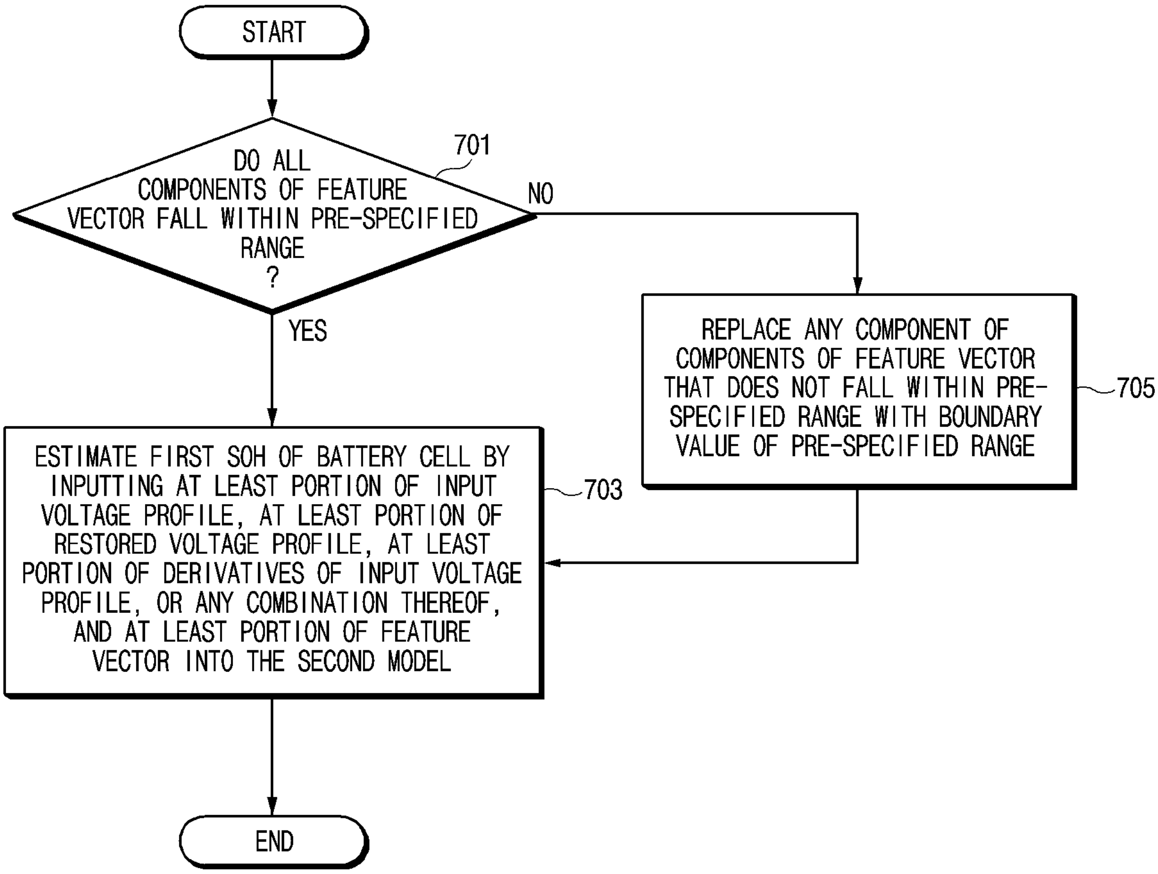
START
DO ALL COMPONENTS OF FEATURE VECTOR FALL WITHIN PRE-SPECIFIED RANGE ?
701
NO
YES
REPLACE ANY COMPONENT OF COMPONENTS OF FEATURE VECTOR THAT DOES NOT FALL WITHIN PRE-SPECIFIED RANGE WITH BOUNDARY VALUE OF PRE-SPECIFIED RANGE
705
ESTIMATE FIRST SOH OF BATTERY CELL BY INPUTTING AT LEAST PORTION OF INPUT VOLTAGE PROFILE, AT LEAST PORTION OF RESTORED VOLTAGE PROFILE, AT LEAST PORTION OF DERIVATIVES OF INPUT VOLTAGE PROFILE, OR ANY COMBINATION THEREOF, AND AT LEAST PORTION OF FEATURE VECTOR INTO THE SECOND MODEL
703
END

FIG.7

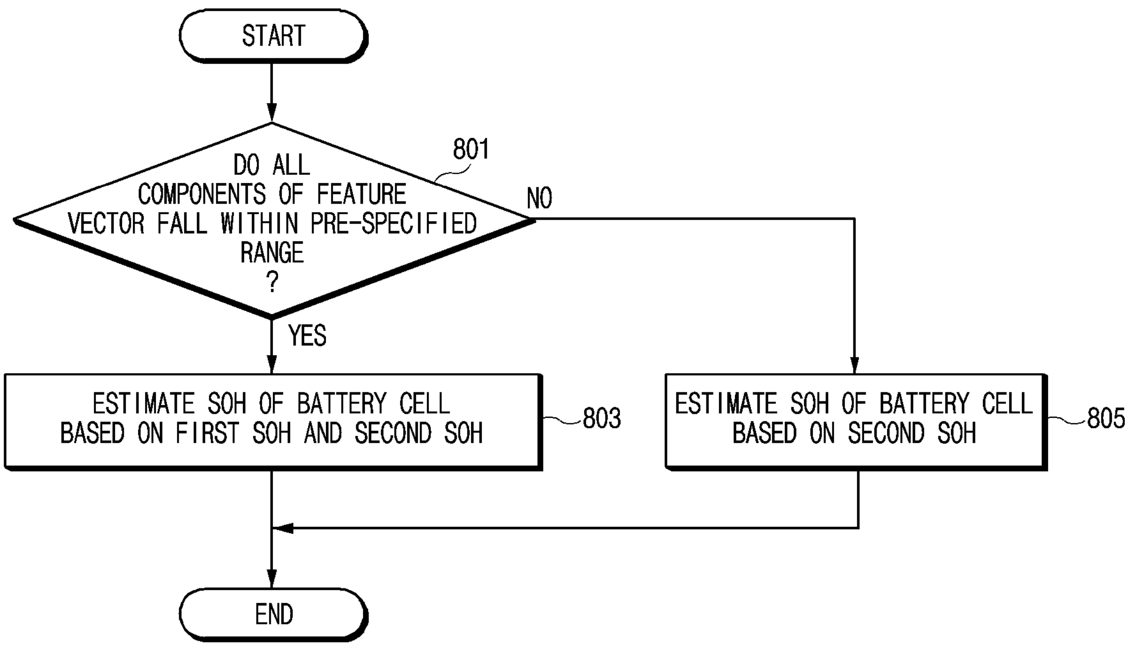
START
DO ALL COMPONENTS OF FEATURE VECTOR FALL WITHIN PRE-SPECIFIED RANGE ?
801
NO
YES
ESTIMATE SOH OF BATTERY CELL BASED ON FIRST SOH AND SECOND SOH
803
ESTIMATE SOH OF BATTERY CELL BASED ON SECOND SOH
805
END

FIG.8

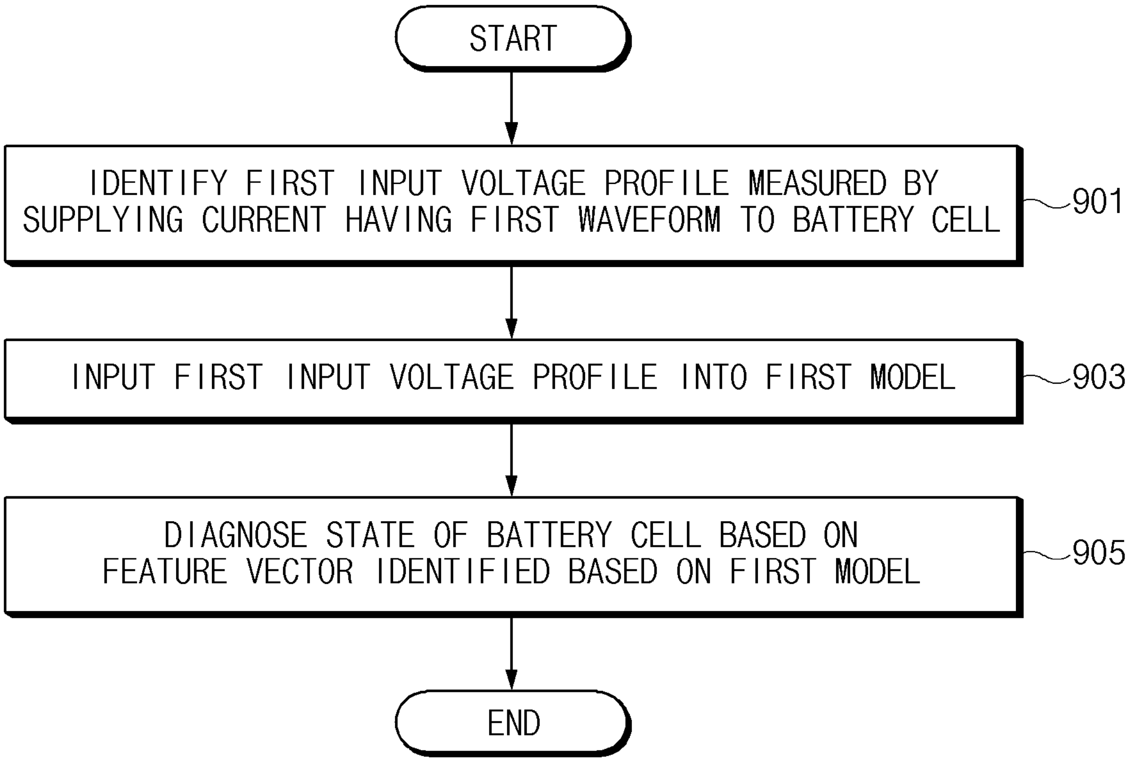
START
IDENTIFY FIRST INPUT VOLTAGE PROFILE MEASURED BY SUPPLYING CURRENT HAVING FIRST WAVEFORM TO BATTERY CELL
901
INPUT FIRST INPUT VOLTAGE PROFILE INTO FIRST MODEL
903
DIAGNOSE STATE OF BATTERY CELL BASED ON FEATURE VECTOR IDENTIFIED BASED ON FIRST MODEL
905
END

FIG.9

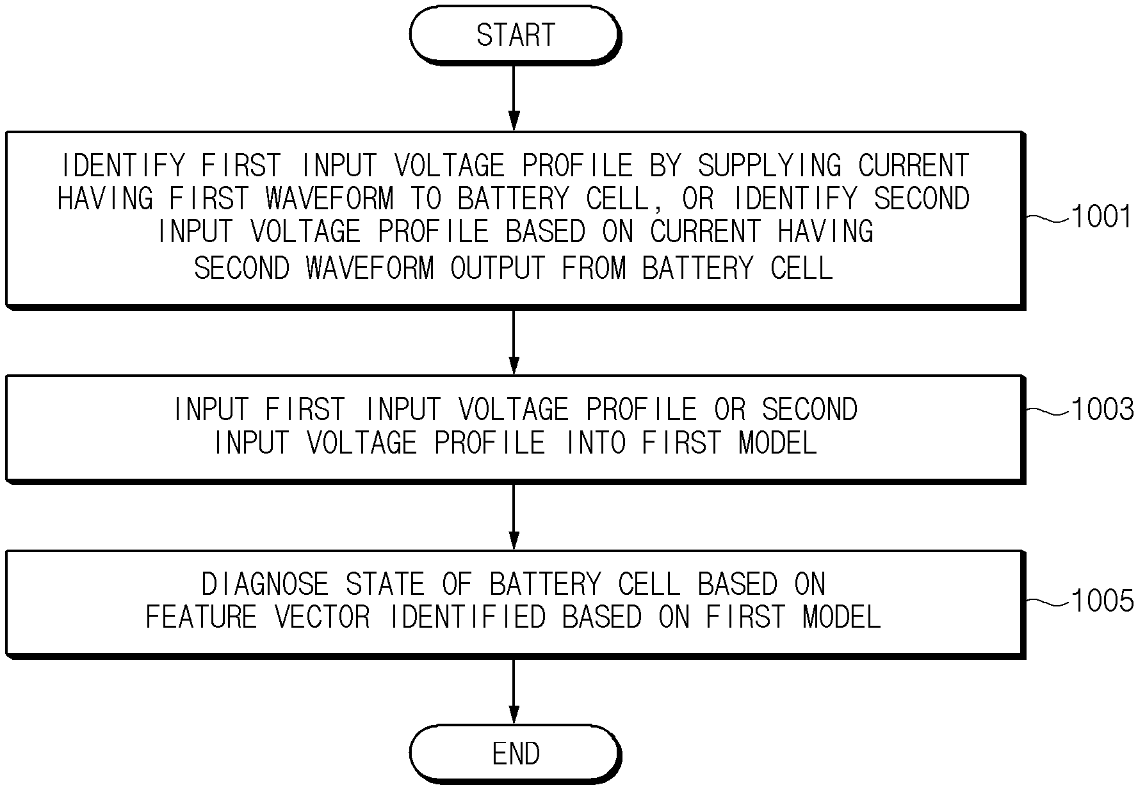
START
IDENTIFY FIRST INPUT VOLTAGE PROFILE BY SUPPLYING CURRENT HAVING FIRST WAVEFORM TO BATTERY CELL, OR IDENTIFY SECOND INPUT VOLTAGE PROFILE BASED ON CURRENT HAVING SECOND WAVEFORM OUTPUT FROM BATTERY CELL
1001
INPUT FIRST INPUT VOLTAGE PROFILE OR SECOND INPUT VOLTAGE PROFILE INTO FIRST MODEL
1003
DIAGNOSE STATE OF BATTERY CELL BASED ON FEATURE VECTOR IDENTIFIED BASED ON FIRST MODEL
1005
END

FIG.10

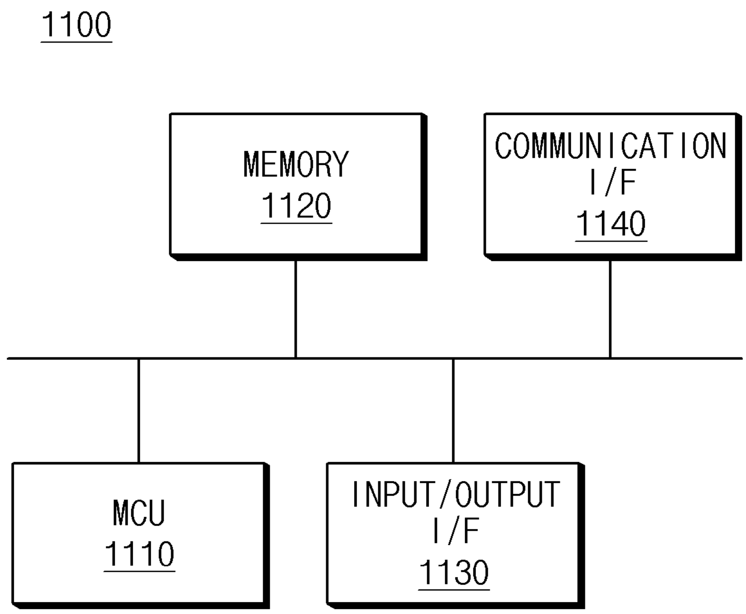
1100
MEMORY
1120
COMMUNICATION
I/F
1140
MCU
1110
INPUT/OUTPUT
I/F
1130

FIG.11

**INTERNATIONAL SEARCH REPORT**

International application No. **PCT/KR2025/009242**

**A. CLASSIFICATION OF SUBJECT MATTER**

**G01R 31/367**(2019.01)i; **G01R 31/392**(2019.01)i; **G01R 31/36**(2006.01)i; **G01R 31/382**(2019.01)i; **G06N 3/0442**(2023.01)i; **G06N 20/00**(2019.01)i

According to International Patent Classification (IPC) or to both national classification and IPC

**B. FIELDS SEARCHED**

Minimum documentation searched (classification system followed by classification symbols)

G01R 31/367(2019.01); B60L 3/00(2006.01); B60L 50/50(2019.01); B60L 58/10(2019.01); G01R 31/36(2006.01); G01R 31/3835(2019.01); G06N 3/04(2006.01); G06N 3/08(2006.01); G06N 7/00(2006.01); G06N 99/00(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 전류(current), 인코딩(encoding), 벡터(vector), 모델(model)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0019316 A (SAMSUNG ELECTRONICS CO., LTD.) 27 February 2019 (2019-02-27)<br>paragraphs [0040]-[0104] and figures 2-6 | 1-17 |
| Y | KR 10-2023-0034546 A (ELECTRONICS AND TELECOMMUNICATIONS RESEARCH INSTITUTE) 10 March 2023 (2023-03-10)<br>paragraphs [0033]-[0038] and figures 1-2 | 1-17 |
| A | KR 10-2395182 B1 (MONA ELECTRIC INC.) 10 May 2022 (2022-05-10)<br>paragraphs [0009]-[0064] and figures 1-10 | 1-17 |
| A | KR 10-2024-0038887 A (LG ENERGY SOLUTION, LTD.) 26 March 2024 (2024-03-26)<br>paragraphs [0043]-[0152] and figures 1-5 | 1-17 |
| A | US 2016-0239759 A1 (SAMSUNG ELECTRONICS CO., LTD.) 18 August 2016 (2016-08-18)<br>paragraphs [0050]-[0131] and figures 1-9 | 1-17 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 September 2025** | **23 September 2025** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**
**Information on patent family members**

International application No.
**PCT/KR2025/009242**

| Patent document cited in search report | Publication date (day/month/year) | Patent family member(s) | Publication date (day/month/year) |
|---|---|---|---|
| KR 10-2019-0019316 A | 27 February 2019 | CN 109425836 A | 05 March 2019 |
| | | CN 109425836 B | 13 December 2022 |
| | | EP 3444626 A1 | 20 February 2019 |
| | | EP 3444626 B1 | 25 September 2024 |
| | | HU E070018 T2 | 28 May 2025 |
| | | JP 2019-036527 A | 07 March 2019 |
| | | JP 7044634 B2 | 30 March 2022 |
| | | US 10928456 B2 | 23 February 2021 |
| | | US 2019-0056452 A1 | 21 February 2019 |
| KR 10-2023-0034546 A | 10 March 2023 | KR 10-2727653 B1 | 08 November 2024 |
| | | US 2023-0076118 A1 | 09 March 2023 |
| KR 10-2395182 B1 | 10 May 2022 | CN 118119856 A | 31 May 2024 |
| | | EP 4443180 A1 | 09 October 2024 |
| | | US 2024-0210482 A1 | 27 June 2024 |
| | | WO 2023-101113 A1 | 08 June 2023 |
| KR 10-2024-0038887 A | 26 March 2024 | CN 118974577 A | 15 November 2024 |
| | | EP 4549968 A1 | 07 May 2025 |
| | | WO 2024-058625 A1 | 21 March 2024 |
| US 2016-0239759 A1 | 18 August 2016 | KR 10-2016-0101506 A | 25 August 2016 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020240087431
- KR 1020250078638